# EUROPÄISCHE PATENTSCHRIFT

(11) **EP 4 260 021 B1**
(45) Veröffentlichungstag und Bekanntmachung des Hinweises auf die Patenterteilung: **02.04.2025**
(21) Anmeldenummer: 21820545.8
(22) Anmeldetag: 26.11.2021
(51) Int. Cl.: G01F 23/284, G01F 25/20

(54) **FÜLLSTANDSMESSVORRICHTUNG UND VERFAHREN ZUM IN-LINE KALIBRIEREN UND/ODER VERIFIZIEREN EINER FÜLLSTANDSMESSVORRICHTUNG**
LEVEL GAUGE AND PROCEDURE FOR IN-LINE CALIBRATION AND/OR VERIFICATION OF A LEVEL GAUGE
JAUGE DE NIVEAU ET PROCEDURE D'ETALONNAGE ET/OU DE VERIFICATION EN LIGNE D'UNE JAUGE DE NIVEAU

(30) Priorität: 10.12.2020 DE 102020132964
(43) Veröffentlichungstag der Anmeldung: 18.10.2023
(73) Patentinhaber: Endress+Hauser SE+Co. KG, 79689 Maulburg (DE)
(72) Erfinder: HEITZ, Ulrich, 64653 Lorsch (DE); THOMANN, Norbert, 79576 Weil am Rhein (DE); STEITZ, Jürgen, 65193 Wiesbaden (DE); REIMELT, Ralf, 79110 Freiburg (DE)
(74) Vertreter: Endress + Hauser Group Services (Deutschland) AG+Co. KG
(86) Internationale Anmeldenummer: PCT/EP2021/083165
(87) Internationale Veröffentlichungsnummer: WO 2022/122416

(56) Entgegenhaltungen:
- DE-A1- 10 136 754
- US-A1- 2009 158 839
- US-A1- 2009 303 106
- US-A1- 2016 103 008

## Beschreibung

Die Erfindung betrifft eine Füllstandsmessvorrichtung zur Mikrowellen-basierten Bestimmung des Füllstands eines Füllguts in einem Behälter. Ferner betrifft die Erfindung ein Verfahren zum in-line Kalibrieren und/oder Verifizieren einer Füllstandsmessvorrichtung.

Mikrowellen-basierte Füllstandsmessvorrichtungen werden in vielen Anwendungen eingesetzt, insbesondere für den Fall, dass ein hohes Maß an Genauigkeit bei der Bestimmung des Füllstands des Füllguts vonnöten ist. Beispielsweise müssen in der Lebensmittel-verarbeitenden, der pharmazeutischen und/oder chemischen Industrie die Mengen in Reaktionsprozessen präzise bestimmt werden. Ebenso ist in der Öl- und Gasindustrie eine genaue Bestimmung eines in einem Behälter befindlichen Füllgutes erforderlich, z.B. für den Fall, dass eine Zahlungshöhe im Handelsverkehr auf Basis einer präzisen Menge bestimmt wird. Je nach Anwendung in den vorstehend genannten Industrien kann das Füllgut bspw. flüssig sein, aber auch aus Feststoff-Partikeln bestehen d.h. im Wesentlichen körnig sein.

Mikrowellen-basierte Füllstandsmessvorrichtungen umfassen typischerweise eine Elektronikeinheit, die der Erzeugung von Sendesignalen und der Verarbeitung von Echosignalen dient und eine an die Elektronikeinheit angeschlossene Aussende-/Empfangseinheit, die zum Aussenden der Sendesignale in Richtung des Füllguts in dem Behälter und zum Empfang der Echosignale dient. Die Aussende-/Empfangseinheit und die Elektronikeinheit sind - je nach Ausgestaltung - als voneinander räumlich getrennt angeordnete Einheiten, welche bspw. mittels eines Kabels miteinander verbunden sind (sogenannte "abgesetzte" Variante) oder als aneinander räumlich angrenzende angeordnete Einheiten ausgebildet (sogenannte "kompakte" Variante). Die Erfindung bezieht sich sowohl auf die abgesetzte als auch auf die kompakte Variante.

In einem Messbetrieb werden von der Aussende-/Empfangseinheit Sendesignale mit einer Frequenz aus dem Mikrowellenbereich oder höherfrequente Sendesignale in Richtung des Füllguts ausgesendet. Durch Reflexion der Sendesignale an einer Oberfläche des Füllguts wird ein Füllgut-Echosignal erzeugt. Dieses wird an die Elektronikeinheit zurück übermittelt, so dass von der Elektronikeinheit aus dem Füllgut-Echosignal der Füllstand des Füllguts bestimmbar ist, bspw. aus einer Laufzeitdifferenz zwischen dem Aussenden des Sendesignals und dem Empfang des reflektierten Füllgut-Echosignal. Das FMCW-Verfahren (Frequency Modulated Continuous Waves), bei dem der Frequenzbereich eines kontinuierlichen Sendesignals verändert und die Distanz durch die Frequenzdifferenz des Sendesignals zum reflektierten Füllgut-Echosignal gemessen wird, wird in mikrowellenbasierten Füllstandsmessvorrichtungen ebenfalls eingesetzt. Neben dem Füllstand sind mit Mikrowellen-basierten Füllstandsmessvorrichtungen als weitere Prozessgrößen auch die Lage einer Grenzschicht in dem Füllgut und eine Dielektrizitätskonstante (auch: DK-Wert) des Füllgut bestimmbar.

Mikrowellen-basierte Füllstandsmessvorrichtungen gibt es in zahlreichen Ausführungen, welche sich prinzipiell in zwei Gruppen unterteilen lassen, die als "frei abstrahlend" oder "geführt" bezeichnet werden. Geführte Mikrowellen-basierte Füllstandsmessvorrichtungen zeichnen sich gegenüber frei abstrahlenden dadurch aus, dass sie eine mit der Aussende-/Empfangseinheit verbundene elektrisch leitfähige Sonde umfassen. Die Sonde ragt in das Füllgut hinein und dient der Weiterleitung der Sendesignale und der Echosignale.

Die vorliegende Anmeldung betrifft derartige geführte Mikrowellen-basierte Füllstandmessvorrichtungen mit einer Sonde, wie bspw. in der DE 10 2014 112 453 A1 beschrieben. Eine geführte Mikrowellen-basierte Füllstandmessvorrichtungen wird von der Anmelderin unter dem Namen "Levelflex" hergestellt und vertrieben.

Eine Vorrichtung und ein Verfahren zur Kalibrierung und/oder Verifizierung einer frei abstrahlenden Mikrowellen-basierten Füllstandsmessvorrichtung mit einer innerhalb eines Behälters angeordneten Reflexionsstelle ist in der Patentschrift DE 44 19 462 C2 offenbart.

Die Patentanmeldung DE 101 36 754 A1 offenbart eine Mikrowellen-basierte Füllstandsmessvorrichtung mit einer Sonde, welche in Längsrichtung der Sonde mehrere Referenzmarken aufweist. Diese dienen als innerhalb des Behälters angeordnete Reflexionenstellen, mittels derer entlang der Sonde ausgesandte Sendesignale reflektiert werden, so dass Reflexionsstellen-Echosignale erzeugt werden.

Es ist wünschenswert, dass auch bei im Wesentlichen während des laufenden Betriebs eine Kalibrierung und/oder Verifizierung der Füllstandsmessvorrichtung vorgenommen werden kann. In diesem Fall wird eine Kalibrierung und/oder Verifizierung bei einem mit Füllgut gefüllten Behälter vorgenommen; dies wird auch als Nasskalibrierung oder in-line Kalibrierung bezeichnet. Hierbei verbleibt die Füllstandsmessvorrichtung in einem eingebauten Zustand, in dem und/oder an dem ggf. mit Füllgut gefüllten Behälter

Der Erfindung liegt daher die Aufgabe zugrunde, für eine geführte, Mikrowellen-basierte Füllstandsmessvorrichtung eine einfache Möglichkeit einer in-line Kalibrierung und/oder Verifizierung anzugeben.

Die Aufgabe wird gelöst durch eine Füllstandsmessvorrichtung und ein Verfahren zum in-line Kalibrieren und/oder Verifizieren.

Bezüglich der Füllstandsmessvorrichtung wird die Aufgabe gelöst durch eine Füllstandsmessvorrichtung zur Mikrowellen-basierten Bestimmung des Füllstands eines Füllguts in einem Behälter, aufweisend
- eine Elektronikeinheit, die zur Erzeugung von Sendesignalen und der Verarbeitung von Echosignalen ausgestaltet ist;
- eine an die Elektronikeinheit angeschlossene Aussende-/Empfangseinheit, die zum Aussenden der Sendesignale in Richtung des Füllguts in dem Behälter und zum Empfang der Echosignale ausgestaltet ist; und
- eine mit der Aussende-/Empfangseinheit verbundene elektrisch leitfähige Sonde, die in das Füllgut hineinragt und der Weiterleitung der Sendesignale und der Echosignale dient, wobei die Aussende-/Empfangseinheit in einem Messbetrieb Sendesignale entlang der Sonde in Richtung des Füllguts aussendet,

wobei durch Reflexion der Sendesignale an einer Oberfläche des Füllguts ein Füllgut-Echosignal erzeugt wird, das entlang Sonde zu der Aussende-/Empfangseinheit zurückgeleitet und an die Elektronikeinheit übermittelt wird, so dass von der Elektronikeinheit aus dem Füllgut-Echosignal der Füllstand des Füllguts bestimmbar ist, dadurch gekennzeichnet, dass
die Füllstandsmessvorrichtung zumindest eine außerhalb des Behälters angeordnete Reflexionsstelle aufweist, welche Reflexionsstelle durch Reflexion des Sendesignals ein Reflexionsstellen-Echosignal erzeugt,
und wobei die Elektronikeinheit anhand des zumindest einen Reflexionsstellen-Echosignals das Füllgut-Echosignal in-line kalibriert und/oder verifiziert.

Gemäß der Erfindung weist die Füllstandsmessvorrichtung ein Kabel auf, wobei die Elektronikeinheit mittels des Kabels an die Aussende-/Empfangseinheit angeschlossen ist und das Kabel der Weiterleitung der Sende- und Echosignale dient, und wobei das Kabel zumindest eine Reflexionsstelle aufweist. Das Kabel ist außerhalb des Behälters angeordnet. Vorteilhaft wird also das Kabel selbst zur Erzeugung des Impedanzsprungs, mittels dessen die außerhalb des Behälters angeordnete Reflexionsstelle gebildet wird, verwendet. Dies hat außerdem den positiven Effekt, dass ein Kabel in der Regel sehr einfach austauschbar ist, so dass sich ein Hinzufügen der Reflexionsstelle außerhalb des Behälters zu einer Füllstandsmessvorrichtung aus dem Stand der Technik zu Kalibrierzwecken als besonders einfach gestaltet (bzw. ggf. deren anschließendes Entnehmen für die Messung).

Bei den Sendesignalen handelt es sich bspw. um hochfrequente Sendesignale d.h. aus der Hochfrequenzmesstechnik, mit einer Frequenz ab 3 MHz bis etwa 30 THz oder darüber hinaus. Eine Reflexionsstelle zeichnet sich dadurch aus, dass an ihr durch einen Impedanzsprung eine teilweise Reflexion des Sendesignals stattfindet. Ist die Lage der Reflexionsstelle fest und bekannt, kann anhand einer Reflexionsstelle eine Kalibrierung und/oder Verifizierung der Füllstandsmessvorrichtung erfolgen.

Im Rahmen der Erfindung ist nun zumindest eine Reflexionsstelle außerhalb des Behälters, für dessen Füllgut die Füllguthöhe mit der Füllstandsmessvorrichtung bestimmbar ist, angeordnet. Die Reflexion zur Erzeugung des bei der Kalibrierung verwendeten Reflexionsstellen-Echosignals findet also bevorzugt nicht ausschließlich an Reflexionsstellen statt, welche innerhalb des (bspw. geschlossenen Behälters) angeordnet sind.

In einer Ausgestaltung der Füllstandsmessvorrichtung weist diese zumindest zwei Reflexionsstellen auf.

In einer Ausgestaltung der Füllstandsmessvorrichtung ist zumindest eine Reflexionsstelle innerhalb des Behälters angeordnet.

In einer Ausgestaltung der Füllstandsmessvorrichtung weist die Sonde innerhalb des Behälters eine End-of-Probe (EOP) Reflexionsstelle auf, welche End-of-Probe (EOP) Reflexionsstelle durch das der Aussende-/Empfangseinheit abgewandte Ende der Sonde gebildet ist.

In einer Ausgestaltung der Füllstandsmessvorrichtung ist das Kabel aufgewickelt und in einer Box angeordnet, wobei die Elektronikeinheit im Wesentlichen unmittelbar an die Box angrenzt und die Box im Wesentlichen unmittelbar an die Aussende-/Empfangseinheit angrenzt.

Für den Fall, dass es sich bei dem Füllstandsmessgerät um die vorstehend erwähnte kompakte Variante ohne Kabel handelt, ist es bspw. möglich, der kompakten Variante mittels entsprechender Verzweigungen ein aufgewickeltes Kabel zum Zweck der Kalibration hinzuzufügen.

In einer Weiterbildung der Füllstandsmessvorrichtung handelt es sich bei dem Kabel um ein Koaxialkabel, mit einem ersten Koaxialkabel-Abschnitt und einem an den ersten Koaxialkabel-Abschnitt angrenzenden zweiten Koaxialkabel-Abschnitt, wobei die Reflexionsstelle durch eine Übergangsstelle zwischen dem ersten Koaxialkabel-Abschnitt und dem zweiten Koaxialkabel-Abschnitt gebildet ist.

In einer ersten Ausgestaltung der vorstehend genannten Weiterbildung weisen eine erste Isolationsschicht des ersten Koaxialkabel-Abschnitts und eine zweite Isolationsschicht des zweiten Koaxialkabel-Abschnitts voneinander verschiedene Dielektrizitätskonstanten auf.

Der erste Koaxialkabel-Abschnitt und der zweite Koaxialkabel-Abschnitt unterscheiden sich also hinsichtlich ihrer voneinander verschiedenen Dielektrizitätskonstanten in ihren jeweiligen Isolationsschichten. Dadurch wird an der Übergangsstelle ein Impedanzsprung im Koaxialkabel verursacht und somit die Reflexionsstelle an der Übergangsstelle zwischen den beiden Koaxialkabel-Abschnitten gebildet.

In einer zweiten Ausgestaltung der vorstehend genannten Weiterbildung sind ein erster Innenleiter und ein erster Außenleiter des ersten Koaxialkabel-Abschnitts sowie ein zweiter Innenleiter und ein zweiter Außenleiter des zweiten Koaxialkabel-Abschnitts derart bemessen, dass sich ein erster Quotient, gebildet aus dem Durchmesser des ersten Innenleiters geteilt durch den Durchmesser des ersten Außenleiters, von einem zweiten Quotienten, gebildet aus dem Durchmesser des zweiten Innenleiters geteilt durch den Durchmesser des zweiten Außenleiters, unterscheidet.

In dieser Ausgestaltung wird also durch die voneinander verschiedenen Quotienten bzw. Verhältnisse der Durchmesser im ersten Koaxialkabel-Abschnitt und im zweiten Koaxialkabel-Abschnitt der Impedanzsprung an der Übergangsstelle bewirkt.

In einer Weiterbildung des Füllstandsmessgeräts handelt es sich bei dem Kabel um ein Koaxialkabel und die Reflexionsstelle des Kabels ist durch eine Stichleitungsschaltung gebildet, wobei die Stichleitungsschaltung mittels einer an einer festen Position des Kabels angeordneten Stichleitung an zumindest einen Leiter des Koaxialkabels, nämlich an einen Innenleiter und/oder an einen Außenleiter des Koaxialkabels, angeschlossen ist.

Beispielsweise umfasst die Stichleitungsschaltung einen Schalter.

Insbesondere umfasst die Stichleitungsschaltung auch weitere Schaltungskomponenten. Mittels der Stellung des Schalters kann bspw. beeinflusst werden, ob in der Stichleitungsschaltung unterschiedliche Schaltungskomponenten (bspw. Widerstände, Induktivitäten, Kapazitäten, etc.) zugeschaltet werden oder ob bspw. an der Stichleitung der Außenleiter mit dem Innenleiter über die Stichleitungsschaltung miteinander kurzgeschlossen sind.

Mittels der Stellung des Schalter ist daher insbesondere ein Amplitudenverhältnis zwischen dem Reflexionsstellen-Echosignal und dem Füllgut-Echosignal einstellbar. Über den Schalter kann bspw. zwischen einem Betrieb mit möglichst kleiner Amplitude des Reflexionsstellen-Echosignals und einem Betrieb mit möglichst großer Amplitude des Reflexionsstellen-Echosignals gewechselt werden.

In einer Ausgestaltung der Füllstandsmessvorrichtung bildet eine Verbindungsstelle zwischen der Aussende-/Empfangseinheit und der Sonde, an welcher Verbindungstelle die Sendesignale in die Sonde einkoppeln, eine Einkoppel-Reflexionsstelle.

In einer Weiterbildung der Füllstandsmessvorrichtung weist die Sonde mindestens eine weitere Reflexionsstelle auf, die ein weiteres Reflexionsstellen-Echosignal erzeugt, wobei die weitere Reflexionsstelle zwischen dem der Aussende-/Empfangseinheit abgewandten Ende der Sonde und der Verbindungsstelle angeordnet ist.

In einer Ausgestaltung der letztgenannten Weiterbildung ist die weitere Reflexionsstelle der Sonde durch einen Übergang zwischen einem ersten Sondenabschnitt und einem zweiten Sondenabschnitt gebildet.

Beispielsweise umfasst die Sonde einen ersten Sondenabschnitt aus einem ersten Material und einen an den ersten Sondenabschnitt angrenzenden zweiten Sondenabschnitt aus einem zweiten Material, wobei das erste Material und das zweite Material voneinander verschiedene HF-Eigenschaften (Hochfrequenz-Eigenschaften) aufweisen.

Alternativ sind beide Sondenabschnitte aus demselben Material, aber zwischen den Sondenabschnitten ein weiteres Material eingebracht, was eine davon verschiedene HF-Eigenschaft aufweist, bspw. in Form eines stiftförmigen Elements (etwa einer "Pinne") zwischen den beiden Sondenabschnitten.

In einer Ausgestaltung der Füllstandsmessvorrichtung ist die weitere Reflexionsstelle der Sonde durch eine lokale Modifizierung der Form der Sonde gebildet.

Die lokale Modifizierung ist insb. ausgewählt aus der Gruppen der folgenden: eine Ausbuchtung, eine Einbuchtung, eine Nut, und eine Bohrung.

Ggf. sind zudem weitere Reflexionsstellen durch Einbauten in den Behälter gebildet, etwa einen vibronischen Füllstandgrenzschalter, ein Rührwerk oder andere seitliche Einbauten

Bezüglich des Verfahrens wird die Aufgabe gelöst durch ein Verfahren zum in-line Kalibrieren und/oder Verifizieren bei der Bestimmung des Füllstands eines Füllguts in einem Behälter, mit einer Mikrowellen-basierten Füllstandsmessvorrichtung nach zumindest einem der vorherigen Ansprüche,
wobei von der Aussende-/Empfangseinheit in einem Messbetrieb Sendesignale entlang der Sonde in Richtung des Füllguts ausgesendet werden, durch Reflexion der Sendesignale an einer Oberfläche des Füllguts ein Füllgut-Echosignal erzeugt wird, das entlang der Sonde zu der Aussende-/Empfangseinheit zurückgeleitet und an die Elektronikeinheit übermittelt wird, so dass von der Elektronikeinheit aus dem Füllgut-Echosignal der Füllstand des Füllguts bestimmt wird,
dadurch gekennzeichnet, dass
das Verfahren die folgenden Schritte umfasst:
   - Erzeugen von zumindest einem Reflexionsstellen-Echosignal, welches durch Reflexion des Sendesignals an einer Reflexionsstelle erzeugt wird, wobei die zumindest eine Reflexionsstelle außerhalb des Behälters angeordnet ist,
   - In-line Kalibrieren und/oder Verifizieren des Füllgut-Echosignals anhand des zumindest einen Reflexionsstellen-Echosignal.

In einer Ausgestaltung des Verfahrens wird anhand des Reflexionsstellen-Echosignals der Einkoppel-Reflexionsstelle Ansatz an der Verbindungsstelle und/oder Korrosion an der Verbindungsstelle detektiert.

Ansatz führt im Allgemeinen zu Reflexionsstellen-Echosignalen, welche eine Phasenverschiebung von 180° zu dem Sendesignal aufweisen. Korrosion verursacht dagegen eher Reflexionsstellen-Echosignale ohne signifikante Phasenverschiebung. Daher lässt sich unter Berücksichtigung der Phasenverschiebung ggf. auch darauf schließen, ob Ansatz oder Korrosion vorliegt.

Die Erfindung sowie weitere vorteilhafte Ausgestaltungen werden nachfolgend anhand von Ausführungsbeispielen näher erläutert. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet.

Es zeigen:
Fig. 1: Eine Ausgestaltung eines erfindungsgemäßen Füllstandsmessgeräts;
Fig. 2: Eine weitere Ausgestaltung eines erfindungsgemäßen Füllstandsmessgeräts;
Fig. 3: Eine Ausgestaltung eines Kabels eines erfindungsgemäßen Füllstandsmessgeräts;
Fig. 4: Eine weitere Ausgestaltung eines Kabels eines erfindungsgemäßen Füllstandsmessgeräts;
Fig. 5a, b: Ausgestaltungen einer Sonde eines erfindungsgemäßen Füllstandsmessgeräts.

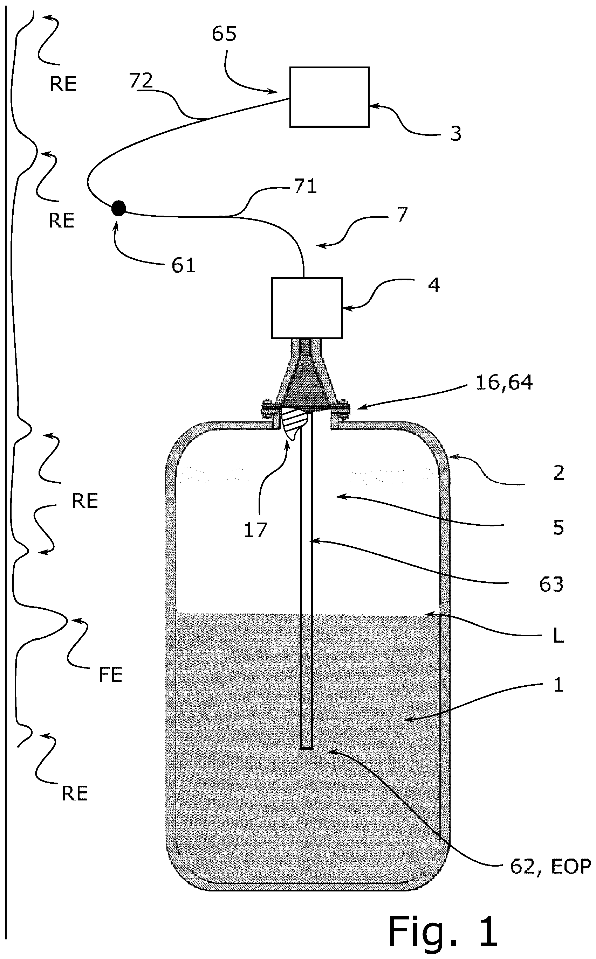

Fig. 1 zeigt eine Ausgestaltung eines erfindungsgemäßen Füllstandsmessgerät. Dieses umfasst eine Sonde 5, die in einen Behälter 2 mit einem Füllgut 1 hineinragt. Über die Sonde 5 werden Sendesignale von einer Aussende-/Empfangseinheit 4 in Richtung des Füllgut 1 geleitet, an einer Oberfläche des Füllguts 1 reflektiert und anschließend über die Sonde 5 zurück an die an einem oberen Abschluss des Behälters 2 angeordnete Aussende-/Empfangseinheit 4 geleitet. Die Aussende-/Empfangseinheit 4 ist über ein Kabel 7 an eine Elektronikeinheit 3 angeschlossen, welche zur Erzeugung der Sendesignale und der Verarbeitung von Echosignalen ausgestaltet ist.

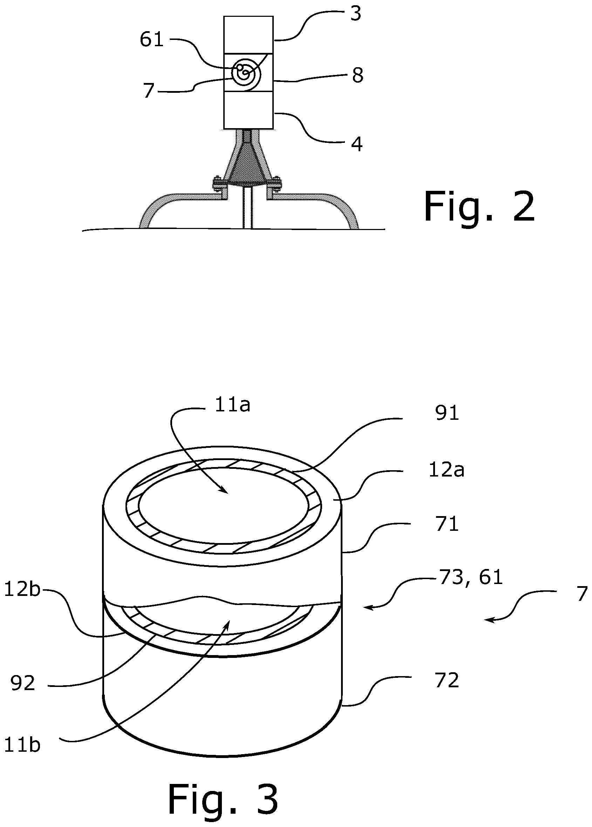

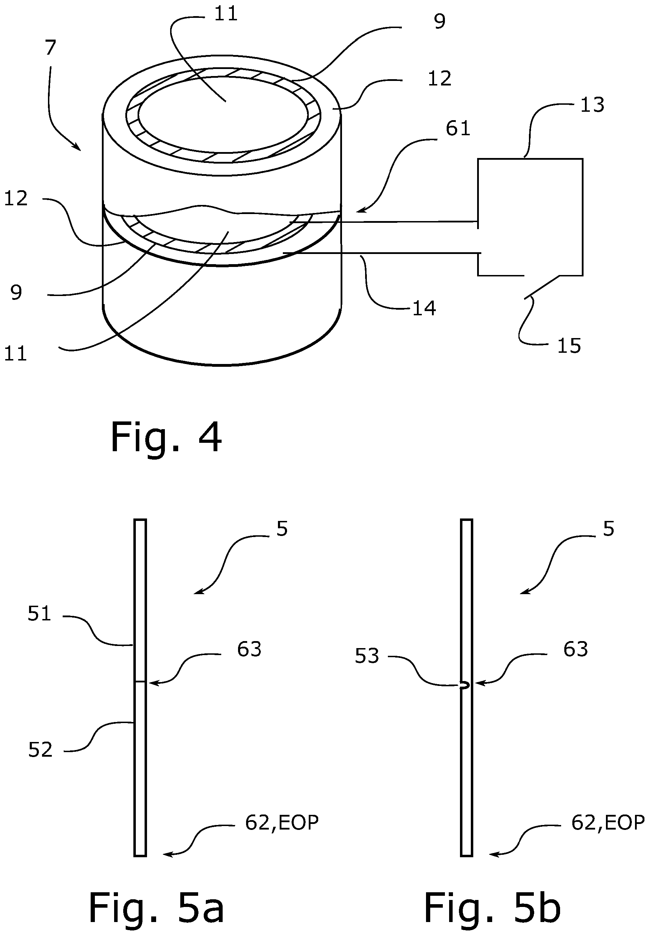

In der in Fig. 1 gezeigten Ausgestaltung handelt es sich um die vorstehend erwähnte abgesetzte Variante des Füllstandsmessgeräts, bei der die Aussende-/Empfangseinheit 4 von der Elektronikeinheit 3 räumlich getrennt angeordnet ist. Erfindungsgemäß ist zumindest eine außerhalb des Behälters 2 angeordnete Reflexionsstelle 61 vorgesehen. Diese ist in Fig.1 in das Kabel 7 eingebracht. Siehe hierzu auch Fig. 3 und 4, in denen die Reflexionsstelle 61 zwischen einem ersten Koaxialkabelabschnitt 71 und einem zweiten Koaxialkabelabschnitt 72 angeordnet ist.

Ferner liegt an der Anschlussstelle zwischen der Elektronikeinheit 3 und dem Kabel 7 eine Nullpunkt-Reflexionsstelle 65 vor.

Ferner umfasst die Füllstandsmessvorrichtung auch weitere Reflexionsstellen 62,63,64 darunter:
- eine EOP-Reflexionsstelle 62, welche an einem der Aussende-/Empfangseinheit 4 abgewandten Ende (EOP) der Sonde 5 angeordnet ist
- eine Einkoppel-Reflexionsstelle 64, die an einer Verbindungsstelle 16 zwischen der Aussende-/Empfangseinheit 4 und der Sonde 5 angeordnet ist, sowie
- eine weitere Sonden-Reflexionsstelle 63, die zwischen der eine EOP-Reflexionsstelle 62 und der Verbindungsstelle 16 angeordnet ist.

Die Echosignale, welche mit der erfindungsgemäßen Füllstandsmessvorrichtung erfasst und von der Elektronikeinheit 3 verarbeitet werden, sind am linken Rand von Fig. 1 im Form einer Funktion Amplitude in Abhängigkeit von der Laufzeit aufgetragen. Die Amplitude ist entlang der horizontalen Achse (von links nach rechts in der Bildebene) aufgetragen, und die Laufzeit, welche in einen Abstand umrechenbar ist, entlang einer vertikalen Achse (von oben nach unten in der Bildebene). Ggf. umfasst die Elektronikeinheit 3 der Füllstandsmessvorrichtung noch entsprechende Komponenten und/oder Algorithmen zur Verstärkung der verschiedenen Echosignale FE, RE.

Die Echosignale FE, RE umfassen zum einen das Füllgut-Echosignal FE, welches bei der Bestimmung des Füllstands L herangezogen wird (indem bspw. aus der Laufzeit des Füllgut-Echosignals FE eine Distanz und daraus der Füllstand L bestimmbar ist), als auch mehrere Reflexionsstellen-Echosignale RE. Letztere werden durch Einfach-Reflexion des Sendesignals an den erfindungsgemäßen Reflexionsstellen 61,62,63,64,65 erzeugt. Selbstverständlich treten auch Mehrfach-Reflexionen auf; diese äußern sich in der Regel nur als ein Grundrauschen in der Amplitude.

Mittels der Reflexionsstellen-Echosignale RE kann eine Kalibrierung und/oder eine Verifizierung vorgenommen werden. Bei der Kalibrierung wird bspw. anhand der bekannten und festen Lage der 61,62,63,64,65 und der erfassten Laufzeit der Reflexionsstellen-Echosignale RE ein konstanter Faktor zur Umrechnung der Laufzeit der Reflexionsstellen-Echosignale RE in eine Wegestrecke bestimmt. Dieser Faktor kann anschließend bei der Kalibrierung und/oder Verifizierung mit einem in dem Füllstandsmessgerät, bspw. in seiner Elektronikeinheit 3, hinterlegten Faktor verglichen werden.

Unter dem Kalibrieren versteht man dabei üblicherweise das Feststellen einer Abweichung; In diesem Fall eine Abweichung zwischen dem über die Reflexionsstellen-Echosignale RE bestimmten (und als korrekt angenommenen) Faktor zu dem hinterlegten Faktor. Das Verifizieren umfasst zusätzlich das Ermitteln des genauen Werts der Abweichung und deren Bewertung. Unter dem Justieren versteht man das Anpassen des Füllstandsmessgeräts in der Weise, dass die festgestellte Abweichung durch die Anpassung ausgeglichen wird. Ggf. wird auch eine Justierung vorgenommen, bei welcher der hinterlegte Faktor auf Basis der Reflexionsstellen-Echosignale RE angepasst wird.

Bei der Verwendung mehrerer Reflexionsstellen-Echosignale RE kann eine Mehrpunkt-Kalibrierung durchgeführt werden, bspw. zumindest eine 2-Punkt Kalibrierung mit Hilfe der Reflexionsstelle 61 des Kabels 7 und der EOP-Reflexionsstelle 62 und zumindest eine 5-Punkt Kalibrierung unter der Berücksichtigung aller in Fig. 1 gezeigten Reflexionsstellen 61,62,63,64,65.

Bevorzugt kann das Kalibrieren und/oder Verifizieren in-line erfolgen, d.h. für ein in eine Prozessanlage eingebautes Füllstandsmessgerät und für den Fall, dass in dem Behälter 2 Füllgut 1 vorhanden ist.

Anhand der Einkoppel-Reflexionsstelle 64 kann ferner in einer Ausgestaltung des erfindungsgemäßen Verfahrens überprüft werden, ob sich Ansatz 17 an der Aussende-/Empfangseinheit 4 gebildet hat oder eher Korrosion vorliegt. Dies wie vorstehend erwähnt bspw. unter der Berücksichtigung einer Phasenbeziehung zwischen ausgesandten Sendesignal und empfangenen Reflexionsstellen-Echosignal RE der Einkoppel-Reflexionsstelle 64.

Wie bereits eingangs erwähnt eignet sich die erfindungsgemäße Lösung sowohl für die in Fig. 1 dargestellte abgesetzte Variante als auch für die Kompaktvariante. Letztere ist in Fig. 2 näher dargestellt, wobei hier die Elektronikeinheit 3 des Füllstandsmessgeräts über eine Box 8 im Wesentlichen unmittelbar an die Aussende-/Empfangseinheit 4 angrenzt. In der Box 8 ist das Kabel 7 aufgerollt, in der die Reflexionsstelle 61 eingebracht ist. Ein derartiges Kabel 7 mit einer Reflexionsstelle 61 kann ggf. über entsprechende Verzweigungsanschlüsse auch einer kompakten Variante des Füllstandsmessgeräts ohne Kabel noch nachträglich hinzugefügt werden.

Fig. 3 zeigt eine Möglichkeit, um ein Kabel 7 mit einer Reflexionsstelle 61 bereitzustellen. In der in Fig. 3 gezeigten Ausgestaltung ist eine perspektivische Ansicht eines Ausschnitts des Kabels 7 näher dargestellt. Zur Weiterleitung der Signale zwischen der Elektronikeinheit 3 und der Aussende-/Empfangseinheit 4 wird hier ein Koaxialkabel eingesetzt, welches prinzipiell einen innenliegenden Innenleiter, einen außenliegenden Außenleiter und eine zwischen dem Innleiter und dem Außenleiter angeordnete Isolationsschicht umfasst. Erfindungsgemäß umfasst das Koaxialkabel 7 der in Fig. 3 gezeigten Ausgestaltung nun einen ersten Koaxialkabelabschnitt 71 und einen zweiten Koaxialkabelabschnitt 72, welche an einer Übergansstelle 73, an der die Reflexionsstelle 61 gebildet ist, aneinander angrenzen.

Der Impedanzsprung an der Reflexionsstelle 61 wird hier bspw. dadurch hervorgerufen, dass sich die Dielektrizitätskonstante einer ersten Isolationsschicht 91 im ersten Koaxialkabelabschnitt 71 von der Dielektrizitätskonstante einer zweiten Isolationsschicht 92 im zweiten Koaxialkabelabschnitt 72 unterscheidet. Ansonsten kann der Querschnitt der beiden Koaxialkabelabschnitte 71,72 im Wesentlichen identisch aufgebaut sein. Die voneinander unterschiedlichen Dielektrizitätskonstanten der Isolationsschichten 91,92 werden bspw. im Wesentlichen nur durch eine entsprechende Auswahl und/oder Anpassung eines Materials für die jeweilige Isolationsschicht 91,92 eingestellt.

Eine alternative Möglichkeit besteht darin, ein Durchmesserverhältnis der leitenden Schichten 11a,12a bzw.11b,12b in den beiden Koaxialkabelabschnitten 71,72 unterschiedlich auszulegen. Auch dadurch wird ein Impedanzsprung an der Übergansstelle 73 bewirkt, so dass eine Reflexionsstelle 61 vorliegt. Insbesondere unterscheidet sich ein Verhältnis aus einem Durchmesser eines ersten Innenleiters 11a zu einem Durchmesser eines ersten Außenleiters 12a in dem ersten Koaxialkabelabschnitt 71 (erster Quotient) von einem Verhältnis aus einem Durchmesser eines zweiten Innenleiters 11b zu einem Durchmesser eines zweiten Außenleiters 12b in dem zweiten Koaxialkabelabschnitt 72 (zweiter Quotient). Dies bspw. auch unter Verwendung einer einheitlichen Isolationsschicht 91,92 und bei ansonsten gleichen Materialien jeweils für Innenleiter 11a,11b und Außenleiter 12a, 12b. Das unterschiedliche Durchmesserverhältnis ist in Fig. 3 nicht explizit maßstabsgetreu dargestellt.

Fig. 4 zeigt eine weitere Möglichkeit, um ein Kabel 7 mit einer Reflexionsstelle 61 auszustatten. In dieser Ausgestaltung ist das Kabel 7 ein einheitliches Koaxialkabel, d.h. mit einheitlichem Innenleiter 11, Außenleiter 12 und Isolationsschicht 9. Die Reflexionsstelle 61 des Kabels 7 ist dadurch gebildet, dass an dieser an den Innenleiter 11 und den Außenleiter 12 Stichleitungen 14 angeschlossen sind. Die Stichleitungen 14 sind in eine Stichleitungsschaltung 13 integriert. In der Stichleitungsschaltung 13 sind ferner ggf. weitere, hier nicht näher dargestellte Schaltungskomponenten integriert, welche typische elektronische Schaltungsgrößen der Stichleitungsschaltung 13 mitbestimmen, d.h. Widerstände, Kapazitäten, Induktivitäten, etc. Im einfachsten Fall ist über die Stichleitungsschaltung 13 der Innenleiter 11 mit dem Außenleiter 12 kurzgeschlossen. Ein derartiger Kurzschluss der Stichleitung 14 führt zu einem vergleichsweise starken Reflexionsstellen-Echosignal RE an der Reflexionsstelle 61, im Vergleich zu dem für die Bestimmung des Füllstands heranzuziehenden Füllgut-Echosignals FE. "Stark" heißt hier hinsichtlich ihrer jeweiligen Amplituden.

In einer bevorzugten Variante ist in der Stichleitungsschaltung 13 noch ein Schalter 15 angeordnet, so dass die Stichleitungsschaltung 13 zwischen einer Variante "offene Stichleitung" und einer Variante "geschlossene Stichleitung" mit miteinander kurzgeschlossenen Innenleiter 11 und Außenleiter 12 umschaltbar ist. Die Stellung "offene Stichleitung" bietet sich bspw. für einen reinen Messbetrieb an, damit hier das Füllgut-Echosignal FE nicht zu sehr durch das Reflexionsstellen-Echosignal RE gestört und damit der Energiebedarf zur Erzeugung des Reflexionsstellen-Echosignal RE reduziert ist. Die Stellung "geschlossene Stichleitung" bietet sich dagegen an für den Fall, dass eine Kalibrierung und/oder Verifizierung vorgenommen wird, um im Kalibrierbetrieb ein besonders prominentes Reflexionsstellen-Echosignal RE mit möglichst großer Amplitude zu erhalten.

Selbstverständlich kann das Kabel 7 auch mehrere derartige, jeweils gleichartige und/oder voneinander verschiedene Reflexionsstellen 61 aufweisen, indem die im Zusammenhang mit den vorstehenden in Fig. 3 und 4 erwähnten Ausgestaltungen entsprechend kombiniert werden.

Ferner kann die Sonde 5 selbst mehrere Reflexionsstellen 62,63 aufweisen, siehe Fig. 5 a, b. Jede Sonde 5 besitzt (natürlicherweise) an ihrem der Aussende-/Empfangseinheit 4 abgewandten Ende eine EOP-Reflexionsstelle 62.

In Fig. 5a weist die Sonde 5 zudem eine weitere Sonden-Reflexionsstelle 63, auf, welche durch die Verwendung zweier aneinandergrenzender Sondenabschnitte 51,52 mit unterschiedlicher Hochfrequenzeigenschaften gebildet ist. An dem Übergang von dem ersten Sondenabschnitte 51 zu dem zweiten Sondenabschnitt 52 findet daher der Impedanzsprung statt. Alternativ bestehen die beiden Sondenabschnitte 51,52 aus demselben Material, wobei zwischen ihnen ein stiftförmiges Element (nicht dargestellt) aus einem anderen Material, d.h. mit unterschiedlicher Hochfrequenzeigenschaft eingebracht wird.

In Fig. 5b wird hingegen in die Sonde 5 eine lokale Modifizierung 53 eingebracht, hier in Form einer Einbuchtung der Sonde 5. Auch die Einbuchtung führt zu einem Impedanzsprung. Die Erfindung umfasst weitere Varianten für lokale geometrische Modifizierungen der Sonde 5, darunter bspw. eine der zuvor genannten Varianten Ausbuchtung, Nut, Bohrung, etc....

Die weitere Sonden-Reflexionsstelle 63 ist in Fig. 5a,5b mittig zwischen der Verbindungsstelle 16 und dem Ende der Sonde 5 mit der EOP-Reflexionsstelle 62 angeordnet. Selbstverständlich umfasst die Erfindung aber auch nicht-mittige Anordnungen bzw. eine Sonde 5 mit mehreren, weiteren Sonden-Reflexionsstellen 63.

### Bezugszeichen und Symbole

- 1: Füllgut
- 2: Behälter
- 3: Elektronikeinheit
- 4: Aussende-/Empfangseinheit
- 5: Sonde
- 51,52: erster, zweiter Sondenabschnitt
- 53: lokale Formmodifizierung
- 61: Reflexionsstelle außerhalb des Behälters
- 62: EOP-Reflexionsstelle
- 63: weitere Reflexionsstelle der Sonde
- 64: Einkoppel-Reflexionsstelle
- 65: Nullpunkt-Reflexionsstelle
- 7: Kabel
- 71,72: erster, zweiter Koaxialkabelabschnitt
- 73: Übergangsstelle
- 8: Box
- 91,92: erste, zweite Isolationsschicht
- 9: Isolationsschicht
- 11a,11b: erster, zweiter Innenleiter
- 11: Innenleiter
- 12a,12b: erster, zweiter Außenleiter
- 12: Außenleiter
- 13: Stichleitungsschaltung
- 14: Stichleitung
- 15: Schalter
- 16: Verbindungstelle
- 17: Ansatz
- L: Füllstand
- EOP: End-of-Probe
- FE: Füllgut-Echosignal
- RE: Reflexionsstellen-Echosignal

## Patentansprüche

1. Füllstandsmessvorrichtung zur Mikrowellen-basierten Bestimmung des Füllstands (L) eines Füllguts (1) in einem Behälter (2), aufweisend
- eine Elektronikeinheit (3), die zur Erzeugung von Sendesignalen und der Verarbeitung von Echosignalen ausgestaltet ist;
- eine an die Elektronikeinheit (3) angeschlossene Aussende-/Empfangseinheit (4), die zum Aussenden der Sendesignale in Richtung des Füllguts (1) in dem Behälter (2) und zum Empfang der Echosignale ausgestaltet ist; und
- eine mit der Aussende-/Empfangseinheit (4) verbundene elektrisch leitfähige Sonde (5), die in das Füllgut (1) hineinragt und der Weiterleitung der Sendesignale und der Echosignale dient,
wobei die Aussende-/Empfangseinheit (4) in einem Messbetrieb Sendesignale entlang der Sonde (5) in Richtung des Füllguts (1) aussendet,
wobei durch Reflexion der Sendesignale an einer Oberfläche des Füllguts (1) ein Füllgut-Echosignal (FE) erzeugt wird, das entlang Sonde (5) zu der Aussende-/Empfangseinheit (4) zurückgeleitet und an die Elektronikeinheit (3) übermittelt wird, so dass von der Elektronikeinheit (3) aus dem Füllgut-Echosignal (FE) der Füllstand (L) des Füllguts (1) bestimmbar ist,
**dadurch gekennzeichnet, dass**
die Füllstandsmessvorrichtung ein Kabel (7) aufweist, wobei die Elektronikeinheit (3) mittels des Kabels (7) an die Aussende-/Empfangseinheit (4) angeschlossen ist und das Kabel (7) der Weiterleitung der Sende- und Echosignale dient,
dass die Füllstandsmessvorrichtung zumindest eine außerhalb des Behälters (2) angeordnete Reflexionsstelle (61) aufweist, welche Reflexionsstelle durch Reflexion des Sendesignals ein Reflexionsstellen-Echosignal (RE) erzeugt und das Kabel (7) die zumindest eine Reflexionsstelle (61) aufweist,
und wobei die Elektronikeinheit (3) anhand des zumindest einen Reflexionsstellen-Echosignals (RE) das Füllgut-Echosignal (FE) in-line kalibriert und/oder verifiziert.

2. Füllstandsmessvorrichtung nach Anspruch 1,
aufweisend zumindest zwei Reflexionsstellen (61, 62).

3. Füllstandsmessvorrichtung nach Anspruch 2,
wobei zumindest eine Reflexionsstelle (62, 63) innerhalb des Behälters (2) angeordnet ist.

4. Füllstandsmessvorrichtung nach Anspruch 3,
wobei die Sonde (5) innerhalb des Behälters (2) eine End-of-Probe (EOP) Reflexionsstelle (62) aufweist, die durch das der Aussende-/Empfangseinheit (4) abgewandte Ende der Sonde (5) gebildet ist.

5. Füllstandsmessvorrichtung nach zumindest einem der vorherigen Ansprüche 1 bis 4, wobei das Kabel (7) aufgewickelt und in einer Box (8) angeordnet ist,
und wobei die Elektronikeinheit (3) im Wesentlichen unmittelbar an die Box (8) und die Box (8) im Wesentlichen unmittelbar an die Aussende-/Empfangseinheit (4) angrenzt.

6. Füllstandsmessvorrichtung nach zumindest einem der vorherigen Ansprüche 1 bis 5, wobei es sich bei dem Kabel (7) um ein Koaxialkabel handelt, mit einem ersten Koaxialkabel-Abschnitt (71) und einem an den ersten Koaxialkabel-Abschnitt angrenzenden zweiten Koaxialkabel-Abschnitt (72),
und wobei die Reflexionsstelle (61) des Kabels (7) durch eine Übergangsstelle (73) zwischen dem ersten Koaxialkabel-Abschnitt (71) und dem zweiten Koaxialkabel-Abschnitt (72) gebildet ist.

7. Füllstandsmessvorrichtung nach Anspruch 6,
wobei eine erste Isolationsschicht (91) des ersten Koaxialkabel-Abschnitts (71) und eine zweite Isolationsschicht (92) des zweiten Koaxialkabel-Abschnitts (72) voneinander verschiedene Dielektrizitätskonstanten aufweisen.

8. Füllstandsmessvorrichtung nach Anspruch 6 oder 7,
wobei ein erster Innenleiter (11a) und ein erster Außenleiter (12a) des ersten Koaxialkabel-Abschnitts (71) sowie ein zweiter Innenleiter (11b) und ein zweiter Außenleiter (12b) des zweiten Koaxialkabel-Abschnitts (72) derart bemessen sind, dass sich ein erster Quotient, gebildet aus dem Durchmesser des ersten Innenleiters (11a) geteilt durch den Durchmesser des ersten Außenleiters (12a), von einem zweiten Quotienten, gebildet aus dem Durchmesser des zweiten Innenleiters (11b) geteilt durch den Durchmesser des zweiten Außenleiters (12), unterscheidet.

9. Füllstandsmessvorrichtung nach zumindest einem der vorherigen Ansprüche 7 bis 8, wobei es sich bei dem Kabel (7) um ein Koaxialkabel handelt und die Reflexionsstelle (61) des Kabels (7) durch eine Stichleitungsschaltung (13) gebildet ist, wobei die Stichleitungsschaltung (13) mittels einer an einer festen Position des Kabels angeordneten Stichleitung (14) an zumindest einen Leiter (11,12) des Koaxialkabels, nämlich an einen Innenleiter (11) und/oder an einen Außenleiter (12) des Koaxialkabels, angeschlossen ist.

10. Füllstandsmessvorrichtung nach zumindest einem der vorherigen Ansprüche,
wobei eine Verbindungsstelle (16) zwischen der Aussende-/Empfangseinheit (4) und der Sonde (5), an welcher Verbindungstelle (16) die Sendesignale in die Sonde (5) einkoppeln, eine Einkoppel-Reflexionsstelle (64) bildet.

11. Füllstandsmessvorrichtung nach zumindest einem der vorherigen Ansprüche, wobei die Sonde (5) mindestens eine weitere Reflexionsstelle (63) aufweist, die ein weiteres Reflexionsstellen-Echosignal (RE) erzeugt,
und wobei die weitere Reflexionsstelle (63) zwischen dem der Aussende-/Empfangseinheit (4) abgewandten Ende der Sonde (5) und der Verbindungsstelle (16) angeordnet ist.

12. Füllstandsmessvorrichtung nach Anspruch 11,
wobei die weitere Reflexionsstelle (63) der Sonde (5) durch einen Übergang zwischen einem ersten Sondenabschnitt (51) und einem zweiten Sondenabschnitt (52) gebildet ist.

13. Füllstandsmessvorrichtung nach Anspruch 11 oder 12,
wobei die weitere Reflexionsstelle (63) der Sonde (5) durch eine lokale Modifizierung (53) der Form der Sonde (5) gebildet ist, wobei die lokale Modifizierung insbesondere ausgewählt aus der Gruppen der folgenden ist: eine Ausbuchtung, eine Einbuchtung, eine Nut, und eine Bohrung.

14. Verfahren zum in-line Kalibrieren und/oder Verifizieren bei der Bestimmung des Füllstands (L) eines Füllguts (1) in einem Behälter (2), mit einer Mikrowellen-basierten Füllstandsmessvorrichtung nach zumindest einem der vorherigen Ansprüche,
wobei von der Aussende-/Empfangseinheit (4) in einem Messbetrieb Sendesignale entlang der Sonde (5) in Richtung des Füllguts (1) ausgesendet werden, durch Reflexion der Sendesignale an einer Oberfläche des Füllguts (1) ein Füllgut-Echosignal (FE) erzeugt wird, das entlang Sonde (5) zu der Aussende-/Empfangseinheit (4) zurückgeleitet und an die Elektronikeinheit (3) übermittelt wird, so dass von der Elektronikeinheit (3) aus dem Füllgut-Echosignal (FE) der Füllstand (L) des Füllguts (1) bestimmt wird,
**dadurch gekennzeichnet, dass**
das Verfahren die folgenden Schritte umfasst:
- Erzeugen von zumindest einem Reflexionsstellen-Echosignal (RE), welches durch Reflexion des Sendesignals an zumindest einer Reflexionsstelle (61) erzeugt wird, wobei die zumindest eine Reflexionsstelle (61) außerhalb des Behälters (2) angeordnet ist,
- In-line Kalibrieren und/oder Verifizieren des Füllgut-Echosignals (FE) anhand des zumindest einen Reflexionsstellen-Echosignals (RE).

15. Verfahren nach Anspruch 14,
wobei anhand des Reflexionsstellen-Echosignals (RE) der Einkoppel-Reflexionsstelle (64) Ansatz (17) an der Verbindungsstelle (16) und/oder Korrosion an der Verbindungsstelle (16) detektiert wird.

## Claims

1. A fill level measuring device for the microwave-based detection of the fill level (L) of a filling material (1) in a container (2), featuring
- an electronic unit (3), which is configured to generate transmission signals and to process echo signals;
- a transmitter/receiver unit (4) connected to the electronic unit (3), which is configured to send the transmission signals toward the filling material (1) in the container (2) and to receive the echo signals; and
- an electrically conductive probe (5) connected to the transmitter/receiver unit (4), which protrudes into the filling material (1) and serves to forward the transmission signals and the echo signals,
wherein the transmitter/receiver unit (4) sends transmission signals along the probe (5) toward the filling material (1) in a measuring mode,
wherein reflection of the transmission signals at a surface of the filling material (1) generates a filling material echo signal (FE), which is fed back along the probe (5) to the transmitter/receiver unit (4) and is transmitted to the electronic unit (3) so that the electronic unit (3) can detect the fill level (L) of the filling material (1) from the filling material echo signal (FE),
**characterized in that**
the fill level measuring device features a cable (7), wherein the electronic unit (3) is connected to the transmitter/receiver unit (4) using the cable (7) and the cable (7) serves to forward the transmission and echo signals,
the fill level measuring device features at least one reflection point (61) arranged outside the container (2), said reflection point generating a reflection point echo signal (RE) through reflection of the transmission signal, and the cable (7) which features the at least one reflection point (61),
and wherein the electronic unit (3) performs in-line calibration and/or verification of the filling material echo signal (FE) using the at least one reflection point echo signal (RE).

2. The fill level measuring device as claimed in claim 1,
featuring at least two reflection points (61, 62).

3. The fill level measuring device as claimed in claim 2,
wherein at least one reflection point (62, 63) is arranged inside the container (2).

4. The fill level measuring device as claimed in claim 3,
wherein the probe (5) inside the container (2) features an end-of-probe (EOP) reflection point (62), which is formed by the end of the probe (5) facing away from the transmitter/receiver unit (4).

5. The fill level measuring device as claimed in at least one of the preceding claims 1 to 4, wherein the cable (7) is coiled up and arranged in a box (8),
and wherein the electronic unit (3) is for the most part directly adjacent to the box (8) and the box (8) is for the most part directly adjacent to the transmitter/receiver unit (4).

6. The fill level measuring device as claimed in at least one of the preceding claims 1 to 5, wherein the cable (7) is a coaxial cable, with a first coaxial cable section (71) and a second coaxial cable section (72) adjacent to the first coaxial cable section,
and wherein the reflection point (61) of the cable (7) is formed by a transition point (73) between the first coaxial cable section (71) and the second coaxial cable section (72).

7. The fill level measuring device as claimed in claim 6,
wherein a first insulating layer (91) of the first coaxial cable section (71) and a second insulating layer (92) of the second coaxial cable section (72) have different dielectric constants.

8. The fill level measuring device as claimed in claim 6 or 7,
wherein a first inner conductor (11a) and a first outer conductor (12a) of the first coaxial cable section (71), and a second inner conductor (11b) and a second outer conductor (12b) of the second coaxial cable section (72) are dimensioned such that a first quotient, formed by the diameter of the first inner conductor (11a) divided by the diameter of the first outer conductor (12a), differs from a second
quotient, formed by the diameter of the second inner conductor (11b) divided by the diameter of the second outer conductor (12).

9. The fill level measuring device as claimed in at least one of the preceding claims 7 to 8, wherein the cable (7) is a coaxial cable and the reflection point (61) of the cable (7) is formed by a stub circuit (13), wherein the stub circuit (13) is connected to at least one conductor (11, 12) of the coaxial cable, that is to say to an inner conductor (11) and/or to an outer conductor (12) of the coaxial cable, using a stub (14) arranged at a fixed position of the cable.

10. The fill level measuring device as claimed in at least one of the preceding claims,
wherein a connection point (16) between the transmitter/receiver unit (4) and the probe (5), at which connection point (16) the transmission signals couple into the probe (5), forms a coupling reflection point (64).

11. The fill level measuring device as claimed in at least one of the preceding claims,
wherein the probe (5) features at least one other reflection point (63), which generates another reflection point echo signal (RE),
and wherein the additional reflection point (63) is arranged between the end of the probe (5) facing away from the transmitter/receiver unit (4) and the connection point (16).

12. The fill level measuring device as claimed in claim 11,
wherein the additional reflection point (63) of the probe (5) is formed by a transition between a first probe section (51) and a second probe section (52).

13. The fill level measuring device as claimed in claim 11 or 12,
wherein the additional reflection point (63) of the probe (5) is formed by a local modification (53) to the shape of the probe (5), wherein the local modification is, in particular, selected from the groups listed below: A protrusion, an indentation, a groove, and a hole.

14. A method for in-line calibration and/or verification when detecting the fill level (L) of a filling material (1) in a container (2), with a microwave-based fill level measuring device as claimed in at least one of the preceding claims,
wherein transmission signals are sent by the transmitter/receiver unit (4) along the probe (5) toward the filling material (1) in a measuring mode, reflection of the transmission signals at a surface of the filling material (1) generates a filling material echo signal (FE), which is fed back along the probe (5) to the transmitter/receiver unit (4) and is transmitted to the electronic unit (3) so that the electronic unit (3) can detect the fill level (L) of the filling materials (1) from the filling material echo signal (FE),
**characterized in that**
the method comprises the following steps:
- Generating at least one reflection point echo signal (RE), which is generated through reflection of the transmission signal at at least one reflection point (61), wherein the at least one reflection point (61) is arranged outside the container (2),
- In-line calibration and/or verification of the filling material echo signal (FE) using the at least one reflection point echo signal (RE).

15. The method as claimed in claim 14,
wherein deposits (17) at the connection point (16) and/or corrosion at the connection point (16) is/are detected using the reflection point echo signal (RE) of the coupling reflection point (64).

## Revendications

1. Dispositif de mesure de niveau destiné à la détermination par micro-ondes du niveau (L) d'un produit (1) dans un réservoir (2), lequel dispositif comprend
- une unité électronique (3), laquelle est conçue pour générer des signaux d'émission et pour traiter des signaux d'écho ;
- une unité d'émission/de réception (4) raccordée à l'unité électronique (3), laquelle unité d'émission/de réception est conçue pour émettre les signaux d'émission en direction du produit (1) dans le réservoir (2) et pour recevoir les signaux d'écho ; et
- une sonde électriquement conductrice (5) reliée à l'unité d'émission/de réception (4), laquelle sonde pénètre dans le produit (1) et sert à la retransmission des signaux d'émission et des signaux d'écho,
l'unité d'émission/de réception (4) émettant, en mode de mesure, des signaux d'émission le long de la sonde (5) en direction du produit (1),
un signal d'écho de produit (FE) étant généré par réflexion des signaux d'émission sur une surface du produit (1), lequel signal est renvoyé le long de la sonde (5) à l'unité d'émission/de réception (4) et transmis à l'unité électronique (3), de sorte que le niveau (L) du produit (1) peut être déterminé par l'unité électronique (3) à partir du signal d'écho de produit (FE),
**caractérisé**
**en ce que** le dispositif de mesure de niveau présente un câble (7), l'unité électronique (3) étant raccordée à l'unité d'émission/de réception (4) au moyen du câble (7), et le câble (7) servant à la transmission des signaux d'émission et d'écho,
**en ce que** le dispositif de mesure du niveau présente au moins un point de réflexion (61) disposé à l'extérieur du réservoir (2), lequel point de réflexion génère un signal d'écho de point de réflexion (RE) par réflexion du signal d'émission et en ce que le câble (7) présente l'au moins un point de réflexion (61), et l'unité électronique (3) étalonnant et/ou vérifiant en ligne le signal d'écho de produit (FE) à l'aide de l'au moins un signal d'écho de point de réflexion (RE).

2. Dispositif de mesure de niveau selon la revendication 1,
lequel dispositif comprend au moins deux points de réflexion (61, 62).

3. Dispositif de mesure de niveau selon la revendication 2,
pour lequel au moins un point de réflexion (62, 63) est disposé à l'intérieur du réservoir (2).

4. Dispositif de mesure de niveau selon la revendication 3,
pour lequel la sonde (5) présente à l'intérieur du réservoir (2) un point de réflexion (62) « End-of-Probe » (EOP), lequel est formé par l'extrémité de la sonde (5) située à l'opposé de l'unité d'émission/de réception (4).

5. Dispositif de mesure de niveau au moins selon l'une des revendications 1 à 4, pour lequel le câble (7) est enroulé et disposé dans une boîte (8),
et pour lequel l'unité électronique (3) est pour l'essentiel directement adjacente à la boîte (8) et la boîte (8) est pour l'essentiel directement adjacente à l'unité d'émission/de réception (4).

6. Dispositif de mesure de niveau selon au moins l'une des revendications 1 à 5, pour lequel le câble (7) est un câble coaxial comprenant une première section de câble coaxial (71) et une deuxième section de câble coaxial (72) adjacente à la première section de câble coaxial,
et pour lequel le point de réflexion (61) du câble (7) est formé par un point de transition (73) entre la première section de câble coaxial (71) et la deuxième section de câble coaxial (72).

7. Dispositif de mesure de niveau selon la revendication 6,
pour lequel une première couche d'isolation (91) de la première section de câble coaxial (71) et une deuxième couche d'isolation (92) de la deuxième section de câble coaxial (72) présentent des constantes diélectriques différentes l'une de l'autre.

8. Dispositif de mesure de niveau selon la revendication 6 ou 7,
pour lequel un premier conducteur intérieur (1a) et un premier conducteur extérieur (12a) de la première section de câble coaxial (71) ainsi qu'un deuxième conducteur intérieur (11 b) et un deuxième conducteur extérieur (12b) de la deuxième section de câble coaxial (72) sont dimensionnés de telle sorte qu'un premier quotient, formé par le diamètre du premier conducteur interne (11a) divisé par le diamètre du premier conducteur externe (12a), diffère d'un deuxième quotient formé par le diamètre du deuxième conducteur interne (11b) divisé par le diamètre du deuxième conducteur externe (12).

9. Dispositif de mesure de niveau selon au moins l'une des revendications précédentes 7 à 8,
pour lequel le câble (7) est un câble coaxial et le point de réflexion (61) du câble (7) est formé par un circuit de dérivation (13), le circuit de dérivation (13) étant raccordé à au moins un conducteur (11, 12) du câble coaxial, à savoir un conducteur interne (11) et/ou un conducteur externe (12) du câble coaxial, au moyen d'une ligne de dérivation (14) disposée en une position fixe du câble.

10. Dispositif de mesure de niveau selon au moins l'une des revendications précédentes,
pour lequel un point de liaison (16) entre l'unité d'émission/de réception (4) et la sonde (5) - point de liaison (16) au niveau duquel les signaux d'émission sont couplés dans la sonde (5) - forme un point de réflexion de couplage (64).

11. Dispositif de mesure de niveau selon au moins l'une des revendications précédentes,
pour lequel la sonde (5) présente au moins un autre point de réflexion (63) qui génère un autre signal d'écho de point de réflexion (RE),
et pour lequel l'autre point de réflexion (63) est disposé entre l'extrémité de la sonde (5) située à l'opposé de l'unité d'émission/de réception (4) et le point de liaison (16).

12. Dispositif de mesure de niveau selon la revendication 11,
pour lequel l'autre point de réflexion (63) de la sonde (5) est formé par une transition entre une première section de sonde (51) et une deuxième section de sonde (52).

13. Dispositif de mesure de niveau selon la revendication 11 ou 12,
pour lequel l'autre point de réflexion (63) de la sonde (5) est formé par une modification locale (53) de la forme de la sonde (5), la modification locale étant notamment choisie dans le groupe constitué par : un évidement, un creux, une rainure et un alésage.

14. Procédé destiné à l'étalonnage et/ou la vérification en ligne lors de la détermination du niveau (L) d'un produit (1) dans un réservoir (2), avec un dispositif de mesure de niveau basé sur des micro-ondes selon au moins l'une des revendications précédentes,
procédé pour lequel des signaux d'émission sont émis par l'unité d'émission/de réception (4) le long de la sonde (5) en direction du produit (1) pendant un mode de mesure, la réflexion des signaux d'émission sur une surface du produit (1) générant un signal d'écho de produit (FE) qui est renvoyé le long de la sonde (5) vers l'unité d'émission/de réception (4) et transmis à l'unité électronique (3), de sorte que l'unité électronique (3) détermine le niveau (L) du produit (1) à partir du signal d'écho de produit (FE),
**caractérisé en ce que**
le procédé comprend les étapes suivantes :
- Génération d'au moins un signal d'écho de point de réflexion (RE), lequel signal est généré par réflexion du signal d'émission en au moins un point de réflexion (61), l'au moins un point de réflexion (61) étant disposé à l'extérieur du réservoir (2),
- Étalonnage et/ou vérification en ligne du signal d'écho de produit (FE) à l'aide de l'au moins un signal d'écho de point de réflexion (RE).

15. Procédé selon la revendication 14,
pour lequel, à l'aide du signal d'écho de point de réflexion (RE) du point de réflexion de couplage (64), on détecte un dépôt (17) au niveau du point de liaison (16) et/ou une corrosion au niveau du point de liaison (16).
